# EUROPEAN PATENT SPECIFICATION

(11) **EP 0 232 117 B1**
(45) Date of publication and mention of the grant of the patent: **04.08.1993**
(21) Application number: 87300722.3
(22) Date of filing: 28.01.1987
(51) Int. Cl.: H01L 29/93

(54) **Semiconductor variable capacitance element**
Halbleiterbauelement mit variabler Kapazität
Dispositif semi-conducteur à capacitance variable

(30) Priority: 31.01.1986 JP 19622/86
(43) Date of publication of application: 12.08.1987
(73) Proprietor: SEIKO INSTRUMENTS INC., Tokyo 136 (JP)
(72) Inventor: Hattori, Yoshio Seiko InstrumentS & Elec. Ltd., Koto-ku Tokyo (JP)
(74) Representative: Miller, Joseph

(56) References cited:
- PATENT ABSTRACTS OF JAPAN, vol. 8, no. 221 (E-271)(1658), 9th October 1984 ; & JP-A-59 105 378 (SEIKO DENSHI KOGYO KK), 18.06.1984
- PROCEEDINGS OF 11th INTERNATIONAL CONGRESS OF CHRONOMETRY, vol 2, 1984, pages 9-12, Besançon, FR ; Y. HATTORI et al. : "Application of floating mos variable capacitor for the watch IC".
- PATENT ABSTRACTS OF JAPAN, vol. 7, no. 8 (E-152)(1153), 13th January 1983 ; & JP-A-57 166 080 (DAINI SEIKOSHA KK), 13.10.1982.
- PATENT ABSTRACTS OF JAPAN, vol. 7, no. 140 (E-182)(1285), 18th June 1983 ; & JP-A-58 53864 (DAINI SEIKOSHA KK), 30.03.1983.
- PATENT ABSTRACTS OF JAPAN, vol. 9, no. 315 (E-365)(2038), 11th December 1985 ; & JP-A-60 147 169 (SEIKO DENSHI KOGYO KK), 03.08.1985.
- U. TIETZE, Ch. SCHENK : "Halbleiterschaltungstechnik", Springer Verlag ; Berlin, DE ; 1983, p. 14-17.

## Description

The present invention relates to semiconductor variable capacitance elements.

Semiconductor variable capacitance elements are known in the literature (see Proceedings, Vol. 2 in 11th International Congress of Chronometry, 1984, edited by The French Society of Microtechnology and Chronometry, p.9).

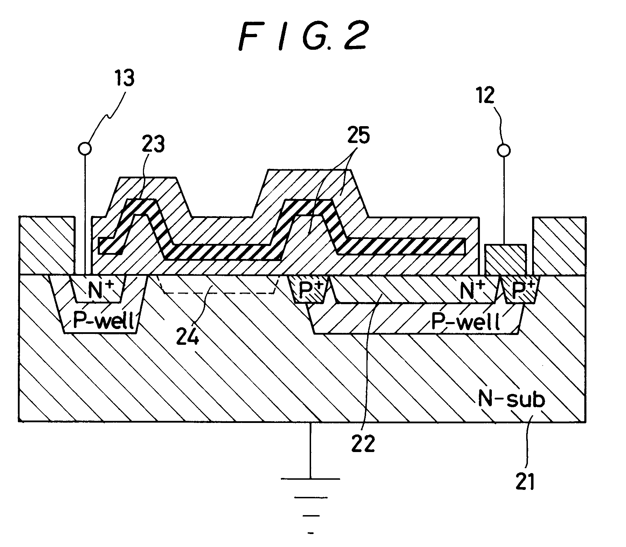

Figure 2 is a sectional view showing the structure of a conventional semiconductor variable capacitance element. On the surface of a semiconductor substrate 21 are provided a capacitance electrode 12 connected to an n-type diffused region 22, a floating electrode 23 covered with an insulator film 25 so as to be insulated from the outside, and a variable electrode 13 for adjusting the electric charge accumulated on the floating electrode 23.

In this semiconductor variable capacitance element, a depletion layer capacitance 24, generated in a surface region of the semiconductor substrate 21 under the floating electrode 23, is controlled by a potential generated at the floating electrode 23 by the electric charge accumulated on the floating electrode 23. Since the floating and capacitance electrodes 23,12 are strongly capacitance-coupled to each other, the potential of the floating electrode 23 is varied in accordance with the voltage applied to the capacitance electrode 12.

Since the capacitance electrode 12 of the conventional semiconductor variable capacitance element is connected directly to an external circuit, a bias voltage which is used in the external circuit is applied directly to the capacitance electrode 12. For this reason, any variation in the voltage applied from the external circuit causes a change in the bias voltage, and this leads to variations in capacitance of the semiconductor variable capacitance element. When the voltage applied from the external circuit is relatively high, a relatively high voltage is applied between the capacitance and the floating electrodes 12, 23 thus causing a minute tunnel current to flow to the floating electrode 23 through the insulator film 25. In consequence, the electric charge accumulated on the floating electrode 23 is changed, and the capacitance of the semiconductdor variable capacitance element also gradually changes with time, disadvantageously.

The present invention seeks to provide a semiconductor variable capacitance element in which a bias voltage which is used in an external circuit connected to a capacitance terminal is prevented from being applied to a capacitance electrode.

According to the present invention there is provided a semiconductor variable capacitance element comprising:
a semiconductor substrate;
a floating electrode disposed above the surface of the substrate for controlling the capacitance of the element;
an insulator film covering the floating electrode for insulation thereof;
a capacitance electrode being capacitively coupled to the floating electrode, characterised by:
a bias terminal coupled to the capacitance electrode for varying the potential of the floating electrode by applying a bias voltage to the capacitance electrode; and a bias cut-off capacitor coupled between an external circuit and the capacitance electrode for cutting off a DC voltage of said external circuit. element, between the bias terminal and the capacitance electrode.

The invention is illustrated, merely by way of example, in the accompanying drawings, in which:-
Figure 1 illustrates a circuit configuration of a semiconductor variable capacitance element according to the present invention;
Figure 2 is a sectional view of the fundamental structure of a conventional semiconductor variable capacitance element; and
Figure 3 is a bias voltage/capacitance characteristic chart showing the relationship between capacitance of a semiconductor variable capacitance element according to the present invention and bias voltage applied to a bias terminal thereof.

In the drawings like parts have been designated by the same reference numerals.

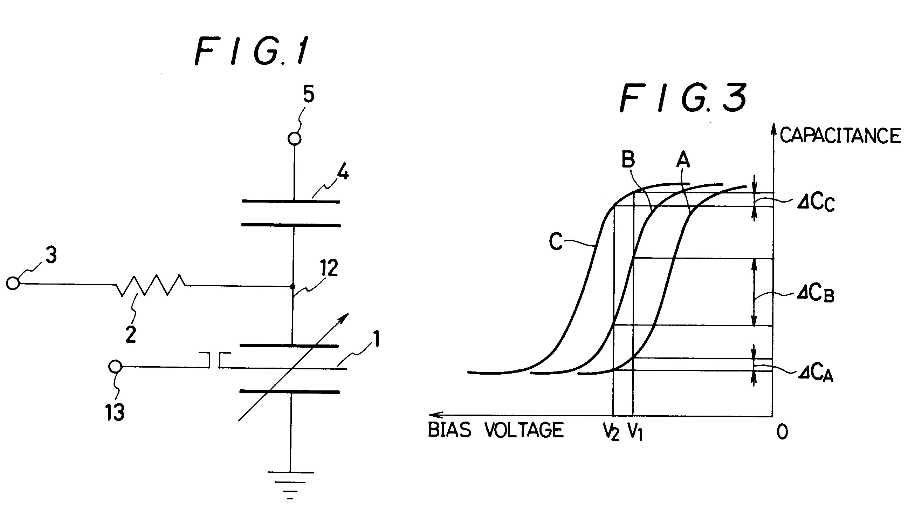

Figure 1 illustrates one embodiment of a semiconductor variable capacitance element 1 according to the present invention. The semiconductor variable capacitance element has a capacitance electrode 12, and a bias terminal 3, for externally applying a bias voltage, is connected to the capacitance electrode 12 through an RF cut-off resistor (or coil) 2. Further, one electrode of a bias cut-off capacitance 4 is connected to the capacitance electrode 12, and the other electrode of the capacitance 4 is connected to an external circuit through a capacitance terminal 5.

A variable electrode 13 controls the electric charge accumulated on the floating electrode 23 described above of the semiconductor variable capacitance element. When a relatively high positive or negative voltage is applied to the variable electrode 13, a tunnel current flows through an extremely thin oxide film disposed between the floating electrode 23 and the variable electrode 13 within the semiconductor variable capacitance element, thus enabling the electric charge accumulated on the floating electrode 23 to be changed. A change in potential generated by the electric charge accumulated on the floating electrode 23 causes a change in the depletion layer capacitance 24 generated in the surface region of the substrate. Since the floating electrode 23 is covered with an oxide film having excellent insulating properties, accumulated electric charge does not change with time unless a variable voltage pulse is applied to the variable terminal 13. In consequence, the semiconductor variable capacitance element enables the electrostatic capacitance formed between the substrate and the capacitance electrode 12 to be varied as desired by changing the amount of electric charge accumulated on the floating electrode 23.

Since the floating electrode 23 and the capacitance electrode 12 are strongly capacitance-coupled to each other, the potential of the floating electrode 23 is greatly affected by the voltage applied to the capacitance electrode 12.

In this embodiment, even when the supply voltage of an external circuit connected to the capacitance terminal 5 is relatively high and therefore a relatively high DC voltage is applied to the terminal 5, the voltage applied to the capacitance electrode 12 is cut off by the bias cut-off capacitance 4. Accordingly, if a constant and relatively low bias voltage is applied to the bias terminal 3, the voltage applied to the bias terminal 3 alone is applied to the capacitance electrode 12. If the bias voltage applied to the bias terminal 3 is minimised, no high voltage is applied between the floating and capacitance electrodes 23,12 so that there is no change with time in the electric charge accumulated on the floating electrode 23.

On the other hand, an AC component applied to the capacitance terminal 5 from an external circuit is cut off by the RF cut-off resistor (or coil) 2.
Accordingly, it will be understood that the capacitance of the semiconductor variable capacitance element is constant as viewed from the capacitance terminal 5 and not affected by the bias terminal 3.

It will also be appreciated that, since a change in potential of the floating electrode 23 causes a change in capacitance of the semiconductor variable capacitance element 1, it is possible to vary the capacitance of the semiconductor variable capacitance element by changing the voltage applied to the bias terminal 3. When the voltage applied to the bias terminal 3 is changed, the voltage applied to the capacitance electrode 12 is changed, and since the potential of the floating electrode 23 changes in accordance with the voltage applied to the capacitance electrode 12, the capacitance can be varied.

Figure 3 is a bias voltage-capacitance characteristic chart showing the relationship between the capacitance of a semiconductor variable capacitance element according to the present invention and the bias voltage applied to the bias terminal 3. The abscissas represents the bias voltage applied to the bias terminal 3, and the ordinate represents the capacitance. Curve A represents initial characteristics. Since the electric charge accumulated on the floating electrode 23 is changed by applying a variable voltage pulse to the variable electrode 13, curve A can be moved parallel to itself as shown by curve B or curve C. In other words, it is possible to obtain various curves such as those which are represented by curves B and C by changing the electric charge on the floating electrode 23. Since the floating electrode 23 is covered with an oxide film having excellent insulating properties, the electric charge accumulated shows no change with time over a relatively long period, i.e. ten years or more. Accordingly, there is no change in characteristics represented by, for example, the curve A, B or C unless a variable voltage pulse is applied to the variable electrode 13.

When a bias voltage V₁ is constant, the capacitance can be varied by applying a variable voltage pulse to the variable electrode 13. It will be understood that, when the bias voltage is changed from V₁ to V₂, the capacitance is changed as shown by Delta-C_{A}, Delta-C_{B} and Delta-C_{C}.

Accordingly, capacitance is varied by changing the bias voltage applied to the bias terminal. Since a voltage applied from an external circuit connected to the capacitance terminal is cut off by the bias cut-off capacitance, a constant and relatively low bias voltage can be applied to the capacitance electrode. There is, therefore, no change in capacitance with time, which means that it is possible to obtain a semiconductor variable capacitance element of high reliability.

Although the present invention has been described in detail with reference to the circuit diagram shown, in an actual semiconductor variable capacitance element, the RF cut-off resistor (or coil) 2 and the bias cut-off capacitance can be formed on a single semiconductor substrate. It is also possible to form a semiconductor variable capacitance element having the above described constituent elements and further fabricate a semiconductor variable capacitance element as a part of a semiconductor integrated circuit.

As will be clear from the above description, the semiconductor variable capacitance element according to the present invention is provided with a bias terminal which enables a bias voltage to be externally applied to the capacitance electrode, thereby allowing the capacitance of the semiconductor variable capacitance element to be also varied in accordance with the bias voltage applied to the bias terminal. Since a voltage applied from an external circuit connected to the capacitance electrode is cut off by the bias cut-off capacitance, a constant and relatively low bias voltage can be applied to the capacitance electrode at all times. Since any bias voltage used in the external circuit is prevented from being unnecessarily applied to the capacitance electrode, it is possible to obtain a semiconductor variable capacitance element which is free from any change in capacitance with time and has high reliability.

## Claims

1. A semiconductor variable capacitance element (1) comprising:
a semiconductor substrate (21);
a floating electrode (23) disposed above the surface of the substrate (21) for controlling the capacitance of the element;
an insulator film (25) covering the floating electrode (23) for insulation thereof;
a capacitance electrode (12) being capacitively coupled to the floating electrode (23), characterised by:
a bias terminal (3) coupled to the capacitance electrode (12) for varying the potential of the floating electrode (23) by applying a bias voltage to the capacitance electrode (12); and a bias cut-off capacitor (4) coupled between an external circuit and the capacitance electrode (12) for cutting off a DC voltage of said external circuit.

2. A semiconductor variable capacitance element as claimed in claim 1 characterised in that the insulator film (25) is an oxide film.

3. A semiconductor variable capacitance element as claimed in claim 1 or 2 characterised by including an RF cut-off element (2) between the bias terminal (3) and the capacitance electrode (12).

4. A semiconductor variable capacitance element as claimed in claim 3 characterised in that the RF cut-off element (2) is a resistance element.

## Patentansprüche

1. Halbleiterelement (1) mit variabler Kapazität umfassend:
ein Halbleitersubstrat (21);
eine über der Oberfläche des Substrats (21) angeordnete floatende Elektrode (23) zur Steuerung der Kapazität des Elementes;
einen die floatende Elektrode (23) zu deren Isolation bedeckenden Isolatorfilm (25);
eine mit der floatenden Elektrode (23) kapazitiv gekoppelte Kapazitätselektrode (12),
**gekennzeichnet durch:**
einen mit der Kapazitätselektrode (12) gekoppelten Vorspannungsanschluß (3) zur Änderung des Potentials der floatenden Elektrode (23) durch Anlegen einer Vorspannung an die Kapazitätselektrode (12); und einen zwischen eine externe Schaltung und die Kapazitätselektrode (12) gekoppelten Vorspannungs-Abschaltkondensator (4) zur Abschaltung einer Gleichspannung der externen Schaltung.

2. Halbleiterelement mit variabler Kapazität nach Anspruch 1,
**dadurch gekennzeichnet,**
daß der Isolatorfilm (25) ein Oxidfilm ist.

3. Halbleiterelement mit variabler Kapazität nach Anspruch 1 oder 2,
**dadurch gekennzeichnet,**
daß es ein HF-Abschaltelement (2) zwischen dem Vorspannungsanschluß (3) und der Kapazitätselektrode (12) enthält.

4. Halbleiterelement mit variabler Kapazität nach Anspruch 3,
**dadurch gekennzeichnet**,
daß das HF-Abschaltelement (2) ein Widerstandselement ist.

## Revendications

1. Un élément semiconducteur à capacité variable (1) comprenant :
un substrat semiconducteur (21);
une électrode flottante (23) disposée au-dessus de la surface du substrat (21) pour commander la capacité de l'élément;
une pellicule isolante (25) recouvrant l'électrode flottante (23) pour isoler cette dernière;
une électrode capacitive (12) qui est couplée de façon capacitive à l'électrode flottante (23), caractérisé par :
une borne de polarisation (3) connectée à l'électrode capacitive (12) pour faire varier le potentiel de l'électrode flottante (23) par l'application d'une tension de polarisation à l'électrode capacitive (12); et un condensateur de blocage de polarisation (4) connecté entre un circuit externe et l'électrode capacitive (12) pour bloquer une tension continue du circuit externe.

2. Un élément semiconducteur à capacité variable selon la revendication 1, caractérisé en ce que la pellicule isolante (25) est une pellicule d'oxyde.

3. Un élément semiconducteur à capacité variable selon la revendication 1 ou 2, caractérisé en ce qu'il comprend un élément de blocage RF (2) entre la borne de polarisation (3) et l'électrode capacitive (12).

4. Un élément semiconducteur à capacité variable selon la revendication 3, caractérisé en ce que l'élément de blocage RF (2) est un élément résistif.
